# EUROPÄISCHE PATENTSCHRIFT

(11) **EP 3 552 280 B1**
(45) Veröffentlichungstag und Bekanntmachung des Hinweises auf die Patenterteilung: **22.03.2023**
(21) Anmeldenummer: 17825139.3
(22) Anmeldetag: 07.12.2017
(51) Int. Cl.: G02F 1/01, H01S 5/02345, H01S 5/024, H01S 5/026, H01S 5/062, H01S 5/042

(54) **LASERANORDNUNG UND VERFAHREN ZUM HERSTELLEN EINER LASERANORDNUNG**
LASER ARRANGEMENT AND METHOD FOR FABRICATING THE SAME
DISPOSITIF LASER ET PROCEDE DE FABRICATION DU MEME

(30) Priorität: 09.12.2016 DE 102016224621; 26.01.2017 DE 102017201285
(43) Veröffentlichungstag der Anmeldung: 16.10.2019
(73) Patentinhaber: Fraunhofer-Gesellschaft zur Förderung der angewandten Forschung e.V., 80686 München (DE)
(72) Erfinder: CHOI, Jung Han, 14089 Berlin (DE); BACH, Heinz-Gunter, 14163 Berlin (DE); YAN, Lei, 19711 Berlin (DE)
(74) Vertreter: Maikowski & Ninnemann Patentanwälte Partnerschaft mbB
(86) Internationale Anmeldenummer: PCT/EP2017/081836
(87) Internationale Veröffentlichungsnummer: WO 2018/104456

(56) Entgegenhaltungen:
- US-A- 6 014 392
- US-A1- 2004 028 099
- US-A1- 2007 183 790
- US-A1- 2012 269 215

## Beschreibung

Die Erfindung betrifft eine Laseranordnung gemäß dem Oberbegriff des Anspruchs 1 sowie ein Verfahren zum Herstellen einer Laseranordnung gemäß dem Oberbegriff des Anspruchs 15.

Eine derartige Laseranordnung weist einen elektroabsorptionsmodulierten Laser (EML) auf, d.h. einen Laser, der eine Lasersektion zum Erzeugen von Laserstrahlung und eine Elektroabsorptionsmodulatorsektion zum Modulieren der in der Lasersektion erzeugten Laserstrahlung aufweist. Eine Laseranordnung mit einem EML ist beispielsweise in der US 9,116,367 B2 und in der US2004/028099 A1 offenbart.

Der Erfindung liegt das Problem zugrunde, eine Laseranordnung mit einem EML möglichst energieeffizient zu betreiben.

Dieses Problem wird durch die Bereitstellung der Laseranordnung mit den Merkmalen des Anspruchs 1 sowie durch die Bereitstellung des Verfahrens gemäß Anspruchs 15 gelöst. Weiterbildungen der Erfindung sind in den abhängigen Ansprüchen angegeben.

Danach wird eine Laseranordnung bereitgestellt, mit
- einem elektroabsorptionsmodulierten Laser (EML), der eine Lasersektion und eine Elektroabsorptionsmodulatorsektion aufweist;
- einer Stromquelle zur Stromversorgung der Lasersektion;
- einer zusätzlich zu der Stromquelle angeordneten Gleichspannungsquelle, über die eine Gleichspannung an eine Diodenstruktur der Elektroabsorptionsmodulatorsektion angelegt werden kann;
- einem Treiber, mit dem dem Laser ein HF-Signal zuführbar ist;
- einer elektrische Verbindung, über die der Treiber mit dem Laser verbunden ist, wobei
- über die elektrische Verbindung eine Gleichstromverbindung, also eine DC-Kopplung, zwischen dem Treiber und dem Laser derart besteht und der Treiber derart ausgebildet ist, dass ein in der Elektroabsorptionsmodulatorsektion des Lasers durch Beleuchtung mit Licht der Lasersektion erzeugter Fotostrom zumindest teilweise dem Treiber zufließt und zur Energieversorgung des Treibers zumindest beiträgt.

Die erfindungsgemäße Laseranordnung nutzt somit den bei Betrieb des Lasers entstehenden und sonst ungenutzten Fotostrom, wodurch die dem Treiber von außen zuzuführende Energie reduziert wird oder dem Treiber gar keine zusätzliche Energie zugeführt werden muss. Mit der erfindungsgemäßen Laseranordnung kann insbesondere ein energieeffizienter optischer Transmitter realisiert werden.

Gemäß einer Ausgestaltung der Erfindung besteht über die elektrische Verbindung auch eine HF-Verbindung zwischen dem Treiber und dem Laser, d.h. eine Verbindung, über die ein hochfrequentes Signal von dem Treiber an den Laser übermittelbar ist. Insbesondere handelt es sich bei der elektrischen Verbindung um eine impedanzangepasste Leitung; z.B. um eine Leitung, deren Impedanz einer Ausgangsimpedanz des Treibers und/oder einer Impedanz des Lasers angepasst ist. Der Treiber umfasst insbesondere eine Treiberschaltung, die wiederum mindestens einen Verstärker aufweist.

Der Fotostrom, der zumindest teilweise zur Speisung des Treibers verwendet wird, entsteht bei Beleuchtung der Elektroabsorptionsmodulatorsektion des Lasers mit Licht, das in der Lasersektion des Lasers erzeugt wird.

Bei dem Treiber handelt es sich beispielsweise um einen single-ended (und damit insbesondere nicht um einen differentiellen) Verstärker. So ist dem Treiber das HF-Signal insbesondere dadurch zuführbar, dass ein Eingang des Treibers mit einem zeitlich variierendem Potential beaufschlagt wird, wobei sich das HF-Signal als Differenz des variierenden Potentials mit einem zeitlich im Wesentlichen konstanten Referenzpotential ergibt. Denkbar ist, dass ein weiterer Eingang des Treibers mit dem Referenzpotential (z.B. einem Massepotential) beaufschlagt wird. Die Erfindung ist jedoch nicht auf einen single-ended Verstärker als Treiber beschränkt. Denkbar ist auch, dass der Treiber eine andere Treiberschaltung umfasst; z.B. eine Treiberschaltung, die einen differentiellen Betrieb ermöglicht.

Denkbar ist insbesondere, dass der Treiber so ausgebildet ist und derart mit dem Laser verschaltet ist, dass der Treiber ausschließlich durch den in der Elektroabsorptionsmodulatorsektion des Lasers erzeugten Fotostrom (über die Gleichstromverbindung) mit Energie versorgbar ist. Möglich ist zudem, dass ein von der Stromquelle generierter Strom zumindest im Wesentlichen nicht in den Treiber fließt.

Beispielsweise ist der Treiber so ausgebildet ist und derart mit dem Laser verschaltet, dass der Treiber seine Verstärkungseigenschaften zumindest im Wesentlichen auch dann beibehält, wenn er ausschließlich durch den in der Elektroabsorptionsmodulatorsektion des Lasers erzeugten Fotostrom mit Energie versorgt wird; d.h. insbesondere in dem Fall, dass eine Gleichstromversorgung des Treiber ausschließlich über die Gleichstromverbindung und z.B. ausschließlich über einen mit der Gleichstromverbindung gekoppelten HF-Ausgang des Treibers erfolgt.

Möglich ist darüber hinaus, dass zwischen der Stromquelle und der Elektroabsorptionsmodulatorsektion keine elektrische Verbindung besteht oder eine während des Betriebes der Laseranordnung zumindest im Wesentlichen nicht stromführende elektrische Verbindung, z.B. ausschließlich über mindestens eine dotierte (insbesondere n-dotierte) Halbleiterschicht des Lasers, ausgebildet ist. Insbesondere besteht auch keine elektrische Verbindung zwischen der Stromquelle und dem Treiber (abgesehen von einer möglichen nicht stromführenden Verbindung, z.B.über die dotierte Halbleiterschicht). Es erfolgt somit kein Stromfluss von der Stromquelle der Lasersektion in den Treiber. Darüber hinaus kann auch zwischen der Gleichspannungsquelle und der Lasersektion keine elektrische Verbindung bestehen oder es ist eine stromlose elektrische Verbindung, insbesondere ausschließlich über mindestens eine dotierte Halbleiterschicht des Lasers, ausgebildet.

Diese (insbesondere strikte) elektrische Trennung der Laser- und der Elektroabsorptionsmodulatorsektion umfasst insbesondere auch eine Trennung eines zum Betreiben der Lasersektion ausgebildeten Schaltkreises der Laseranordnung und eines zum Beaufschlagen der Elektroabsorptionsmodulatorsektion mit einem Modulationssignal vorgesehenen Schaltkreises. Mit einer derartigen Trennung dieser Schaltkreise können störende Kopplungen zwischen den Schaltkreisen vermieden werden, wodurch z.B. einer Entstehung eines optischen Chirps entgegengewirkt wird.

Zudem ist mit Hilfe der Spannungsquelle z.B. eine stabile Spannungsversorgung und/oder eine Arbeitspunkteinstellung der Elektroabsorptionsmodulatorsektion ohne eine Beeinflussung des Betriebs der Lasersektion möglich. Darüber hinaus ermöglicht die elektrische Trennung der Stromquelle der Lasersektion von dem Treiber eine Stromversorgung des Treibers ausschließlich oder zumindest im Wesentlichen ausschließlich mit dem in der Elektroabsorptionsmodulatorsektion generierten Fotostrom und somit einen besonders energiesparenden Betrieb des Lasers.

Denkbar ist wie oben bereits erwähnt, dass die Energieversorgung des Treibers hauptsächlich durch den in der Elektroabsorptionsmodulatorsektion des Lasers erzeugten Fotostrom erfolgt. Es ist demnach möglich, dass eine separate Spannungsquelle zur Versorgung des Treibers vorhanden ist, über die zusätzlich zu dem Fotostrom elektrische Energie an den Treiber geliefert wird. Denkbar ist allerdings auch, dass die Energieversorgung des Treibers zumindest im Wesentlichen allein durch den in dem Laser generierten Fotostrom erfolgt und z.B. die Spannungsquelle zur Versorgung des Treibers entfällt. Entsprechend kann dann auch auf eine (teure, HF-kritische und platzbeanspruchende) HF-Entkopplungsspule verzichtet werden, über die eine externe Versorgungsspannung in den Treiber eingekoppelt wird. Ein Verzicht auf die HF-Entkopplungsspule kann insbesondere wegen des geringeren Platzbedarfs z.B. bei einem Array mit mehreren erfindungsgemäßen Laseranordnungen günstig sein.

Gemäß einer anderen Weiterbildung der Erfindung ist die Laseranordnung so ausgebildet, dass zumindest im Wesentlichen der gesamte in der Elektroabsorptionsmodulatorsektion des Lasers erzeugte Fotostrom zur Energieversorgung des Treibers genutzt wird. Gemäß dieser Variante wird also im Wesentlichen der gesamte in dem EML entstehende Fotostrom über die Gleichstromverbindung dem Treiber zugeführt. Denkbar ist jedoch durchaus auch, dass nur ein Teil des Fotostroms dem Treiber zufließt und z.B. ein anderer Teil des Fotostroms zur Speisung eines weiteren Verbrauchers der Laseranordnung verwendet wird oder über einen Widerstand abfließt.

Gemäß einem weiteren Ausführungsbeispiel der Erfindung handelt es sich bei dem Treiber um einen Wanderwellenverstärker ("Travelling Wave Amplifier" - TWA), wobei der Fotostrom insbesondere verstärkenden Transistoren des Wanderwellenverstärkers zugeleitet wird. Beispielsweise sind die einzelnen Verstärker (Transistoren) in einer single-ended Konfiguration ausgeführt und werden beispielsweise entsprechend nicht differentiell betrieben. Die Erfindung ist jedoch nicht auf eine bestimmte Ausgestaltung des Treibers beschränkt. Vielmehr können im Prinzip beliebige geeignete Treiber (insbesondere Verstärkerschaltungen) verwendet werden. Geeignete Treiber sind z.B. so ausgebildet ist und derart mit dem Laser verschaltet, dass der Treiber seine Verstärkungseigenschaften beibehält, wenn er ausschließlich durch den in der Elektroabsorptionsmodulatorsektion des Lasers erzeugten Fotostrom mit Energie versorgt wird, wie oben bereits erläutert.

Möglich ist auch, dass die erfindungsgemäße Laseranordnung eine Impedanzanpassungsschaltung aufweist, die eine Anpassungsinduktivität, einen Anpassungswiderstand und/oder eine Gleichstromblockierkapazität (realisiert z.B. durch einen Gleichstromblockierkondensator - "DC-Blocking-Kondensator") aufweist. Die Gleichstromblockierkapazität wirkt insbesondere bei einer Spannungsversorgung des Treibers zusätzlich zu der Energieversorgung durch den Fotostrom einem DC-Leistungsverlust, insbesondere in einer Terminierungsimpedanz des Treibers, entgegen. Denkbar ist allerdings auch, dass die Impedanzanpassungsschaltung keine Gleichstromblockierkapazität aufweist.

Die Impedanzanpassungsschaltung ist insbesondere ein Teil des Lasers und z.B. durch die Elektroabsorptionsmodulatorsektion ausgebildet oder mit ihr verbunden; insbesondere ist die Impedanzanpassungsschaltung mit einer Diodenstruktur der Elektroabsorptionsmodulatorsektion gekoppelt. Denkbar ist jedoch auch, dass die Impedanzanpassungsschaltung in die elektrische Verbindung zwischen dem Treiber und dem EML integriert ist; insbesondere ist die Impedanzanpassungsschaltung Bestandteil einer flexiblen Leitung, die die elektrische Verbindung ausbildet. Durch Verlagerung der Impedanzanpassungsschaltung in die elektrische Verbindung kann z.B. die Herstellung der Elektroabsorptionsmodulatorsektion des Lasers vereinfacht werden. Denkbar ist beispielsweise, dass die Impedanzanpassungsschaltungen bei der Herstellung eines Arrays mit einer Mehrzahl erfindungsgemäßer Laseranordnungen in die jeweilige elektrische Verbindung verlagert sind.

Darüber hinaus können der Treiber, die elektrische Verbindung und der Laser der erfindungsgemäßen Laseranordnung monolithisch integriert sein, d.h. diese Bauelemente sind insbesondere auf einem gemeinsamen Substrat ausgebildet. Eine monolithische Integration kann z.B. mit InP-, GaAs-, SiGe-, SiP- CMOS-Technologie oder einer ähnlichen Technologie realisiert werden. Beipspielsweise ist hierbei aufgrund des verminderten Energiebedarfs der erfindungsgemäßen Laseranordnung eine thermische Entkopplung des Treibers und des EMLs nicht zwingend erforderlich.

Denkbar ist allerdings auch ein hybrider Aufbau, bei dem der Treiber und der EML auf separaten Substraten angeordnet und insbesondere über eine ebenfalls separat ausgebildete elektrische Verbindung miteinander verbunden sind; z.B. über eine weiter unten erläuterte "Flexline".

Möglich ist auch, dass die erfindungsgemäße Laseranordnung eine Gleichstromspannungsquelle aufweist, über die eine Gleichspannung an eine aktive Region der Elektroabsorptionsmodulatorsektion angelegt werden kann. Die Gleichstromspannungsquelle dient z.B. zum Anlegen einer Sperrspannung an eine Diodenstruktur der Elektroabsorptionsmodulatorsektion des EMLs.

Gemäß einer anderen Weiterbildung der Erfindung ist die elektrische Verbindung durch eine flexible Leitung ausgebildet. Beispielsweise handelt es sich bei der flexiblen Leitung um eine "Flexline", d.h. um eine flexible Leitung, die ein dielektrisches flexibles Trägermaterial aufweist, auf dem eine Mehrzahl von (insbesondere metallischen) Leitungen (z.B. in Form von Leiterbahnen) angeordnet ist. Als Trägermaterial weist die flexible Leitung z.B. ein Polymer (etwa ein Polyimid) auf. Beispielsweise ist die flexible Leitung als Koplanarstreifenleitung ausgebildet.

Mit Hilfe der flexiblen Leitung ist eine Verbindung des Treibers mit dem Laser auch bei einer größeren Entfernung dieser Komponenten möglich, so dass der Treiber in einem Abstand von dem Laser angeordnet werden kann, um eine möglichst gute thermische Entkopplung des Treibers und des Lasers voneinander zu realisieren. Die Verbindung der flexiblen Leitung (oder einer sonstigen Leitung, die die elektrische Verbindung ausbildet) mit dem Treiber und/oder dem Laser erfolgt z.B. per Flip-Chip-Bonding.

Gemäß einer anderen Weiterbildung der Erfindung umfasst die Laseranordnung eine thermoelektrische Kühlvorrichtung zum Kühlen des elektroabsorptionsmodulierten Lasers; insbesondere, um die Temperatur des Lasers (insbesondere der Elektroabsorptionsmodulatorsektion) möglichst konstant zu halten. Beispielsweise ist der EML auf der thermoelektrischen Kühlvorrichtung angeordnet.

Es wird jedoch darauf hingewiesen, dass die erfindungsgemäße Laseranordnung aufgrund der Nutzung des anderenfalls zur Erwärmung des Lasers beitragenden Fotostroms nicht zwingend eine Kühlvorrichtung benötigt. Auch muss nicht unbedingt ein größerer Abstand zwischen dem Treiber und dem Laser vorgesehen werden. Vielmehr ist auch eine monolithische Integration möglich, wie oben bereits erläutert.

Wie oben bereits angedeutet kann die Erfindung auch ein Array mit einer Mehrzahl von erfindungsgemäßen Laseranordnungen betreffen, z.B. ein Array mit 2, 4, 8, ... Laseranordnungen (Kanälen).

Die Erfindung betrifft auch ein Verfahren zum Herstellen einer Laseranordnung, insbesondere einer wie oben beschrieben ausgebildeten Laseranordnung, wobei das Verfahren die Schritte aufweist:
- Bereitstellen eines elektroabsorptionsmodulierten Lasers, der eine Lasersektion und eine Elektroabsorptionsmodulatorsektion aufweist;
- Bereitstellen einer Stromquelle zur Stromversorgung der Lasersektion und einer zusätzlich zu der Stromquelle angeordneten Gleichspannungsquelle, über die eine Gleichspannung an eine Diodenstruktur der Elektroabsorptionsmodulatorsektion angelegt werden kann;
- Bereitstellen eines Treibers, mit dem dem Laser ein HF-Signal zuführbar ist;
- Herstellen einer elektrischen Verbindung zwischen dem Treiber und dem Laser, wobei
- die Laseranordnung so konfiguriert wird, dass über die elektrische Verbindung eine Gleichstromverbindung zwischen dem Treiber und dem Laser derart besteht, dass ein in der Elektroabsorptionsmodulatorsektion des Lasers durch Beleuchtung mit Licht der Lasersektion erzeugter Fotostrom zumindest teilweise dem Treiber zufließt und zur Energieversorgung des Treibers zumindest beiträgt.

Das Bereitstellen des elektroabsorptionsmodulierten Lasers und/oder des Treibers umfasst insbesondere auch ein Herstellen des Lasers bzw. des Treibers. Darüber hinaus können die oben in Verbindung mit der erfindungsgemäßen Laseranordnung beschriebenen Ausführungsbeispiele natürlich analog auch zur Weiterbildung des erfindungsgemäßen Verfahrens verwendet werden.

Die Erfindung wird im Folgenden anhand von Ausführungsbeispielen unter Bezugnahme auf die Figuren näher erläutert. Es zeigen:
- Figur 1: schematisch eine Laseranordnung gemäß einem ersten Ausführungsbeispiel der Erfindung;
- Figur 2: eine Laseranordnung gemäß einem zweiten Ausführungsbeispiel der Erfindung in perspektivischer Ansicht;
- Figur 3: ein Schaltbild einer Laseranordnung gemäß einem dritten Ausführungsbeispiel der Erfindung;
- Figur 4: eine Abwandlung der Laseranordnung aus Figur 3;
- Figur 5: eine weitere Abwandlung der der Laseranordnung aus Figur 3;
- Figur 6: ein Schaltbild einer Laseranordnung gemäß einem vierten Ausführungsbeispiel der Erfindung;
- Figur 7: eine Abwandlung der Laseranordnung aus Figur 6;
- Figur 8: ein Schaltbild einer Laseranordnung gemäß einem fünften Ausführungsbeispiel der Erfindung;
- Figur 9: ein Schaltbild einer Laseranordnung gemäß einem sechsten Ausführungsbeispiel der Erfindung; und
- Figur 10: ein Schaltbild einer Laseranordnung gemäß einem siebten Ausführungsbeispiel der Erfindung.

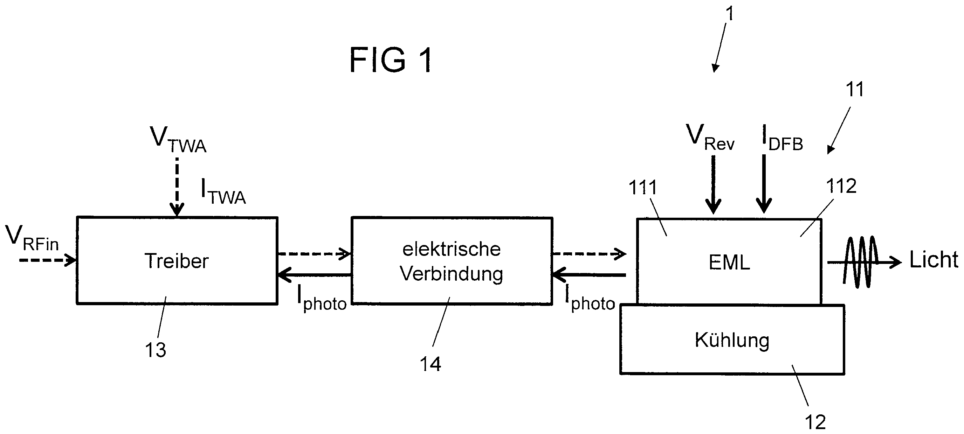

Die in Figur 1 dargestellte erfindungsgemäße Laseranordnung 1 umfasst einen elektroabsorptionsmodulierten Laser (EML) 11, der eine Lasersektion 111 (zum Beispiel in Form eines DFB- oder DBR-Lasers) und eine Elektroabsorptionsmodulatorsektion 112 aufweist. Zur Kühlung des Lasers 11 kann eine (z.B. thermoelektrische) Kühlvorrichtung 12 vorhanden sein, auf der der Laser 11 angeordnet ist. Die Kühlvorrichtung 12 ist jedoch lediglich optional.

Zur Ansteuerung des Lasers 11, insbesondere zur Übermittlung eines HF-Signals, umfasst die Laseranordnung 1 einen Treiber 13, insbesondere in Form eines Wanderwellenverstärkers (TWA). Der Treiber 13 dient insbesondere zur Verstärkung eines hochfrequenten Eingangssignals V_{RFin} und zum Speisen des Lasers 11 mit dem verstärkten HF-Signal über eine elektrische Verbindung 14.

Die elektrische Verbindung 14 realisiert nicht nur eine HF-Verbindung zwischen dem Treiber 13 und dem Laser 11, sondern stellt gleichzeitig auch eine Gleichstromverbindung zwischen dem Treiber 13 und dem Laser 11 bereit. Darüber hinaus ist die Laseranordnung 1 so konfiguriert, dass ein in der Elektroabsorptionsmodulatorsektion 112 des Lasers 11 bei Bestrahlung mit Licht der Lasersektion 111 erzeugter Fotostrom Iₚₕₒₜₒ zumindest teilweise über die elektrische Verbindung 14 dem Treiber 13 zufließt und zur Energieversorgung des Treibers 13 zumindest beiträgt.

Denkbar ist insbesondere, dass die Energieversorgung des Treibers 13 ausschließlich durch den Fotostrom Iₚₕₒₜₒ erfolgt. Möglich ist allerdings z.B. auch, dass dem Treiber 13 über eine Spannungsquelle eine zusätzliche Versorgungsspannung V_{TWA} zugeführt wird. Insbesondere ist der Treiber 13 so beschaffen, dass er sowohl eine Energieversorgung ausschließlich durch den Fotostrom Iₚₕₒₜₒ als auch mit der zusätzlichen Versorgungsspannung V_{TWA} ermöglicht.

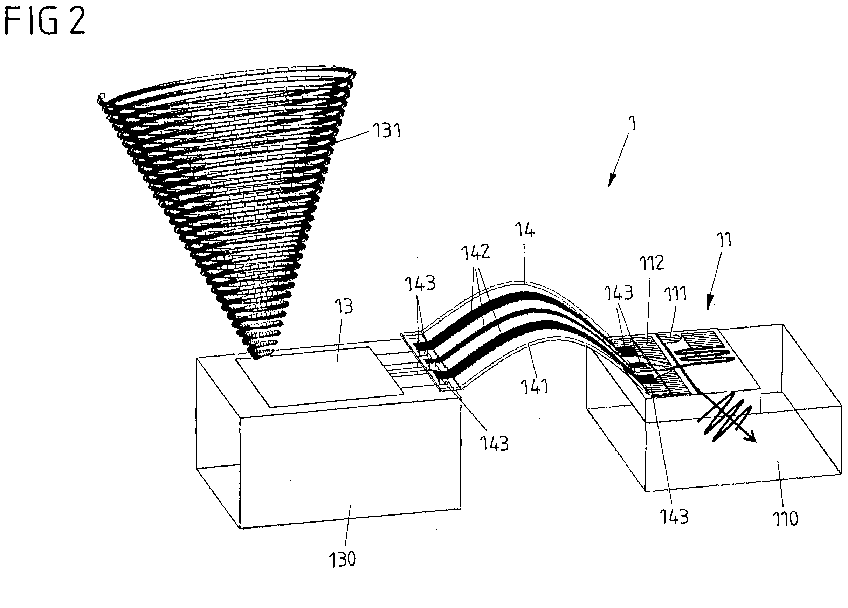

Eine mögliche hybride Ausgestaltung der erfindungsgemäßen Laseranordnung 1 ist in Figur 2 dargestellt. Dort ist der Treiber 13 als integrierter Schaltkreis auf einem ersten Substrat 130 angeordnet, während der EML 11 als Halbleiterstruktur auf einem separaten zweiten Substrat 110 ausgebildet ist.

Der Treiber 13 und der EML 11 sind über eine ebenfalls separate elektrische Verbindung 14 miteinander gekoppelt, wobei die elektrische Verbindung 14 als flexible Leitung ausgeformt ist, d.h. als eine Leitung, die mehrere auf einem flexiblen Substrat 141 angeordnete Leiterbahnen 142 umfasst. Die Leiterbahnen 142 sind über Kontakte (Bumps) 143 mit Ausgangsleitungen des Treibers 13 bzw. Eingangsleitungen des Lasers 11 verbunden.

Der Treiber 13 ist zudem mit einer breitbandigen Terminierungsspule (Entkopplungsspule) 131 gekoppelt, über die dem Treiber 13 eine Versorgungsspannung zuführbar ist. Die Versorgungsspannung wird zusätzlich zu der Versorgung durch den über die elektrische Verbindung 14 zugeführten Fotostrom des Lasers 11 bereitgestellt. Eine derartige zusätzliche Spannungsversorgung und somit auch die Terminierungsspule 131 sind jedoch lediglich optional.

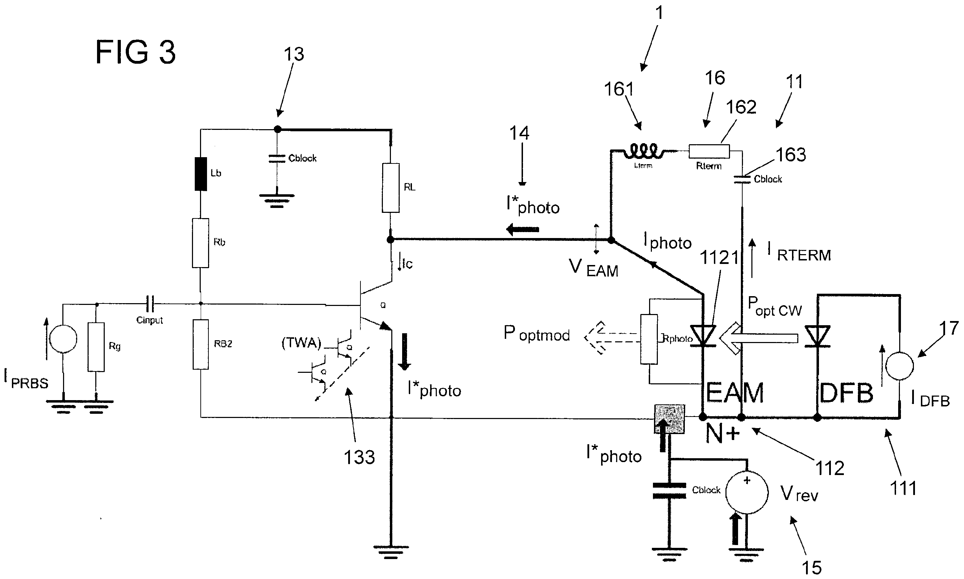

In Figur 3 ist ein Schaltbild eines weiteren Ausführungsbeispiels der erfindungsgemäßen Laseranordnung 1 gezeigt. Danach weist die Laseranordnung 1 zudem eine Gleichspannungsquelle 15 auf, über die eine Gleichspannung (Sperrspannung Vᵣₑᵥ) an eine Diodenstruktur 1121 der Elektroabsorptionsmodulatorsektion 112 des Lasers 11 angelegt werden kann. Des Weiteren ist eine Stromquelle 17 zur Stromversorgung der Lasersektion 111 vorhanden (Versorgungsstrom I_{DFB}).

Auf eine separate Spannungsversorgung des Treibers 13 wurde jedoch verzichtet, d.h. die Energie zum Betrieb des Treibers 13 wird allein durch den über die elektrische Verbindung 14 von dem Laser 11 zugeführten Gleichstrom I*ₚₕₒₜₒ zur Verfügung gestellt, so dass die einzigen zum Betrieb der Laseranordnung 1 benötigten Energiequellen die Gleichspannungsquelle 15 und die Stromquelle 17 sind.

Mittels der Diodenstruktur 1121 und in Abhängigkeit von der dem Laser 11 über den Treiber 13 zugeführten HF-Spannung wird die von der Lasersektion 111 erzeugte kontinuierliche Lichtstrahlung (P_{optCW}) moduliert, wobei der EML modulierte Strahlung (P_{optmod}) emittiert und in der Elektroabsorptionsmodulatorsektion 112 der Fotostrom Iₚₕₒₜₒ entsteht. Der Fotostrom Iₚₕₒₜₒ wird wie oben bereits erläutert über die elektrische Leitung 14 dem Treiber 13, und zwar insbesondere dessen Verstärkungstransistoren 133 (TWA) zugeführt.

Des Weiteren umfasst die Laseranordnung 1 eine Impedanzanpassungsschaltung 16 zur Anpassung insbesondere der Impedanz der Elektroabsorptionsmodulatorsektion 112 des Lasers 11 an die Impedanz der Verbindung 14 und des Treibers 13, um Reflexionen des Treibersignals möglichst gering zu halten. Die Impedanzanpassungsschaltung 16 ist im Ausführungsbeispiel der Figur 3 entsprechend als Abschlussimpedanzschaltung des Lasers 11 ausgebildet und umfasst eine Anpassungsinduktivität 161 ("Lₜₑᵣₘ"), einen Anpassungswiderstand 162 (Abschlusswiderstand Rₜₑᵣₘ) sowie eine Gleichstromblockierkapazität 163 ("C_{block}"). Die Anpassungsinduktivität 161, der Anpassungswiderstand 162 und die Gleichstromblockierkapazität 163 sind in Serie geschaltet.

Die Gleichstromblockierkapazität 163 verhindert insbesondere ein Abfließen eines Teils des Fotostroms Iₚₕₒₜₒ und eines auf die Spanungsquelle 15 zurückgehenden Stromes I_{RTERM} über den Abschlusswiderstand Rₜₑᵣₘ. Entsprechend wird der Treiber 13 zumindest im Wesentlichen durch den von dem Laser 11 zum Treiber 13 fließenden Gleichstrom I*ₚₕₒₜₒ gespeist, wobei hier der dem Treiber 13 zufließende Gleichstrom I*ₚₕₒₜₒ dem erzeugten Fotostrom Iₚₕₒₜₒ entspricht (d.h. I*ₚₕₒₜₒ = Iₚₕₒₜₒ).

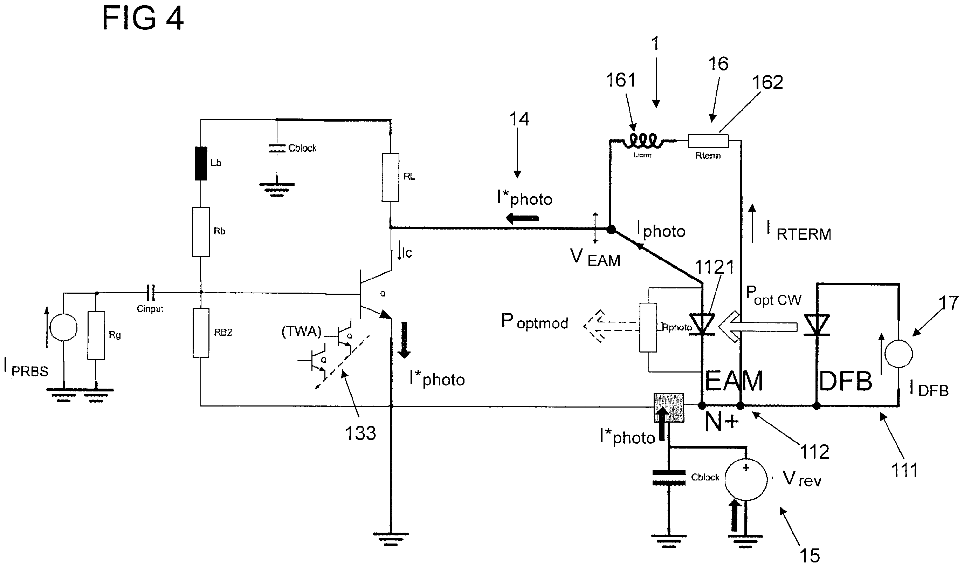

Denkbar ist auch, dass auf die Gleichstromblockierkapazität 163 verzichtet und dieser durch einen Kurzschluss ersetzt wird, wodurch die Herstellung der Impedanzanpassungsschaltung vereinfacht werden kann. Diese Abwandlung ist in Figur 4 dargestellt. In diesem Fall wird der Gleichstrom I_{RTERM} zusammen mit dem in der Elektroabsorptionsmodulatorsektion 112 generierten Fotostrom Iₚₕₒₜₒ dem Treiber 13 zufließen, so dass sich für den den Treiber 13 speisenden Strom I*ₚₕₒₜₒ ergibt: I*ₚₕₒₜₒ = Iₚₕₒₜₒ + I_{RTERM}.

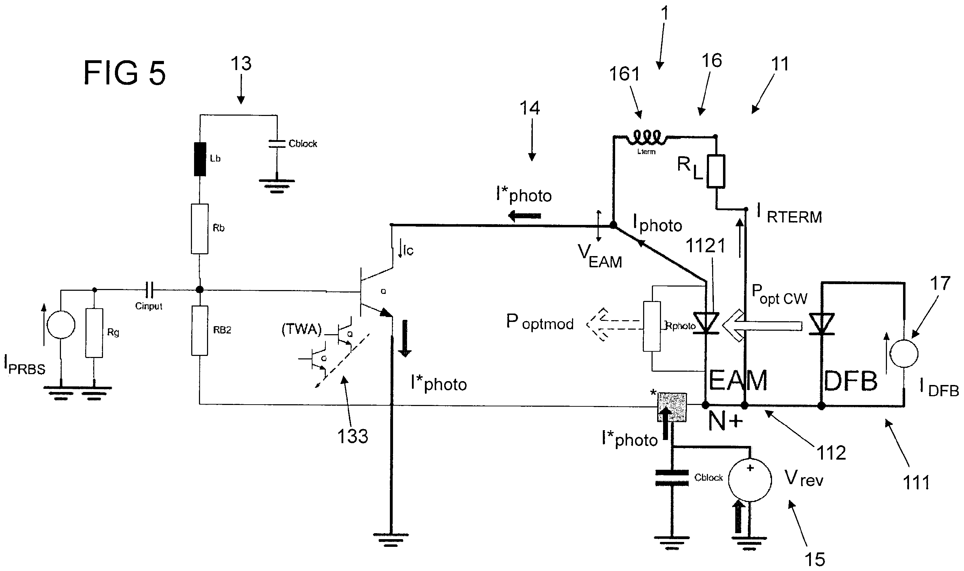

Denkbar ist auch, dass der Abschlusswiderstand Rₜₑᵣₘ den Ausgangswiderstand ("pull-up"-Widerstand) R_{L} des Treibers 13 ersetzt (insbesondere bei einer monolithischen Ausführung der Laseranordnung 1) und die Speisung des Treibers 13 unterstützend zum Fotostrom aus der Elektroabsorptionsmodulatorsektion 112 über den Abschlusswiderstand Rₜₑᵣₘ (= R_{L}) erfolgt. Auf den treiberseitigen Widerstand R_{L} am Transistor Q wird verzichtet ("Open-Collector"-Trei-berkonfiguration), wie dies in Figur 5 gezeigt ist. Hierdurch vereinfacht sich insbesondere der Aufbau des mit einem Geringstrom der Spannungsquelle 15 (Vᵣₑᵥ) versorgten treiberseitigen Basisspannungsteilers (umfassend die Widerstände RB2 und Rb); insbesondere dadurch, dass die mit dem Widerstand Rb in Reihe geschaltete Induktivität Lb nun unmittelbar geerdet ist. Über eine Kapazität Cᵢₙₚᵤₜ und einem Widerstand R_{g} sowie den Basisspannungsteiler wird ein modulierter Hochfrequenzeingangsstrom I_{PRBS} den Transistoren 133 zugeführt.

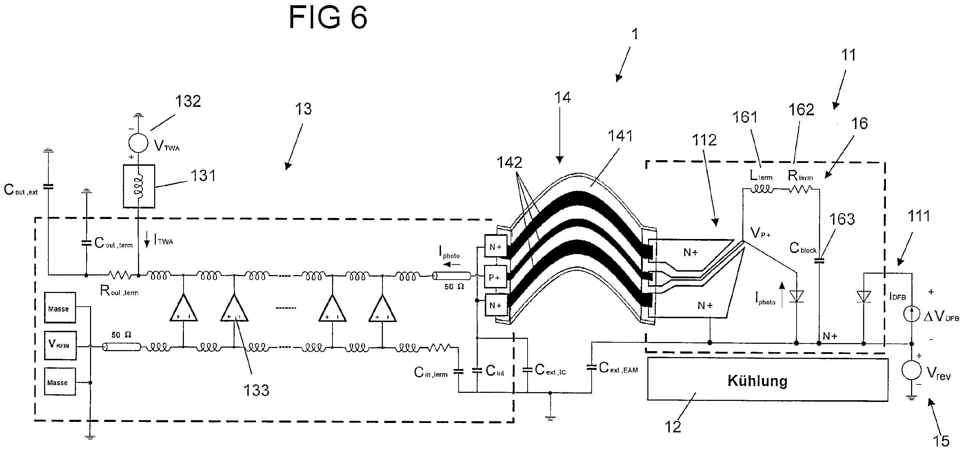

Figur 6 zeigt ein Schaltbild einer erfindungsgemäßen Laseranordnung 1, die analog zum Ausführungsbeispiel der Figur 3 ausgebildet ist, wobei jedoch weitere Einzelheiten des als Wanderwellenverstärker ausgebildeten Treibers 13 dargestellt sind. Ebenfalls analog zur Figur 3 umfasst die Laseranordnung der Figur 6 eine als Abschlussimpedanzschaltung der Elektroabsorptionsmodulatorsektion 112 des Lasers 11 ausgebildete Impedanzanpassungsschaltung 16.

Des Weiteren ist die elektrische Leitung 14 als flexible Leitung mit einem flexiblen Substrat 141 und darauf angeordneten Leiterbahnen 142 ausgebildet. Der Treiber 13 kann zudem zusätzlich über eine Spannungsquelle 132 (Versorgungsspannung V_{TWA}) und eine HF- Terminierungsspule 131 versorgt werden. Durch die Nutzung des Fotostroms Iₚₕₒₜₒ, der wie oben erläutert aufgrund des vorhandenen Blockingkondensators 163 dem tatsächlich dem Treiber 13 zufließendem Gleichstrom I*ₚₕₒₜₒ entspricht, ergibt sich eine Energieeinsparung beim Betrieb des Treibers 13 von V_{TWA} × Iₚₕₒₜₒ.

Der Wanderwellenverstärker weist insbesondere mehr als eine Verstärkerstufe auf. Wanderwellenverstärker sind an sich jedoch bekannt, so dass von weiteren Erläuterungen abgesehen wird. Es wird allerdings darauf hingewiesen, dass die Erfindung nicht auf die Verwendung von Wanderwellenverstärkern begrenzt ist. So könnte durchaus auch ein Verstärker mit nur einer Verstärkerstufe als Treiber verwendet werden.

Des Weiteren zeigt Fig. 6 Kapazitäten C_{in,term}, C_{ext,EAM}, Cᵢₙₜ and C_{ext,IC}, über die ein HF-Masseanschluss der Laseranordnung 1 (des Treibers 13 und der Elektroabsorptionsmodulatorsektion 112) erfolgt, wobei ein Abfließen des Fotostroms Iₚₕₒₜₒ nach Masse jedoch verhindert wird. Ausgangsseitig bezüglich der rücklaufenden Wellen umfasst der Treiber 13, dem ein Eingangssignal V_{RFIN} zugeführt wird, ein Terminierungsnetzwerk mit einem Widerstand R_{out,term} und Kapazitäten C_{out,term}, C_{out,ext}. Im Übrigen wird auf die Erläuterungen zur Figur 4 verwiesen.

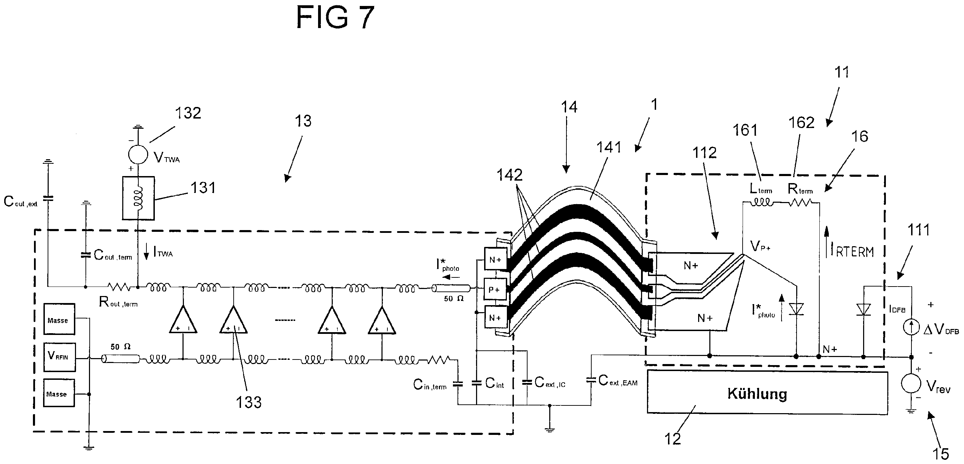

Figur 7 zeigt eine zur Figur 4 analoge Abwandlung der Figur 6, wonach die Impedanzanpassungsschaltung 16 ohne die Gleichstromblockierkapazität 163 ausgebildet ist. Dies reduziert z.B. die zur Herstellung der Elektroabsorptionsmodulatorsektion 112 erforderlichen Herstellungsschritte. Denkbar ist zudem, dass die treiberseitige Spannungsquelle 132 (V_{TWA}) entfällt.

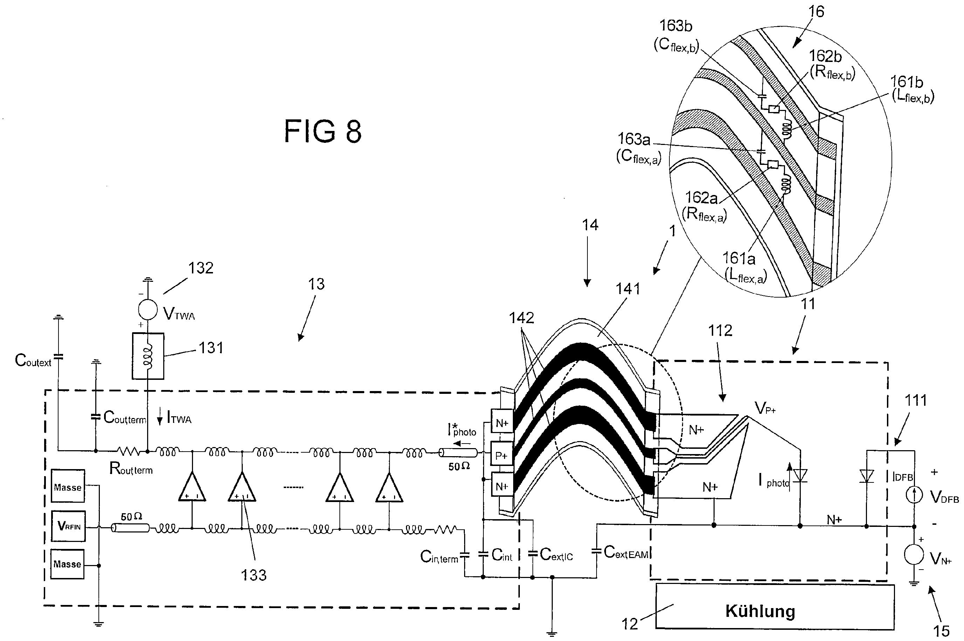

Figur 8 betrifft eine weitere Abwandlung der erfindungsgemäßen Laseranordnung 1, wonach die Impedanzanpassungsschaltung 16 nicht als Abschlussimpedanzschaltung ausgebildet ist, sondern in die als flexible Leitung ausgefomte elektrische Verbindung 14 integriert ist. Entsprechend sind zwischen den Leiterbahnen 142 der elektrischen Verbindung 14 Anpassungsinduktivitäten 161a, 161b (L_{flex,a}, L_{flex,b}) , Anpassungswiderstände 162a, 162b (R_{flex,a}, R_{flex,b}) sowie Gleichstromblockierkapazitäten 163a, 163b (C_{flex,a}, C_{flex,b}) angeordnet; insbesondere in Form von Strukturen, die ebenfalls auf dem Träger 141 der elektrischen Verbindung 14 und dort zwischen den Leiterbahnen 142 angeordnet sind. Denkbar ist, dass der erzeugte Fotostrom Iₚₕₒₜₒ über den Anpassungswiderstand 162 unterstützt wird. Möglich ist auch, dass in Bezug auf die elektrische Verbindung 14 ein Potential verwendet wird (mit dem z.B. die äußeren der Leiterbahnen verbunden sind), das höher liegt als die Masse des Treibers 13 und einem Abfließen eines Teils des Fotostroms über den Anpassungswiderstand 162 somit entgegengewirkt wird.

Von den Induktivitäts-, Widerstands-, und Kapazitätsstrukturen L_{flex,a}, L_{flex,b} ,R_{flex,a}, R_{flex,b}, C_{flex,a}, C_{flex,b} befindet sich jeweils eine zwischen zwei benachbarten Leiterbahnen 142 , wobei die Strukturenzusammen eine Gesamtanpassungsinduktivität, einen Gesamtanpassungswiderstand und eine Gesamtblockierkapazität ergeben. Die Induktivitäts-, Widerstands-, und Kapazitätsstrukturen L_{flex,a,} L_{flex,b} ,R_{flex,a}, R_{flex,b}, C_{flex,a}, C_{flex,b} befinden sich auf einer dem Laser 11 (insbesondere der Elektroabsorptionsmodulatorsektion 112) zugewandten Hälfte der elektrischen Verbindung 14 (insbesondere im Bereich eines der Elektroabsorptionsmodulatorsektion 112 zugewandten Endes der elektrischen Verbindung 14).

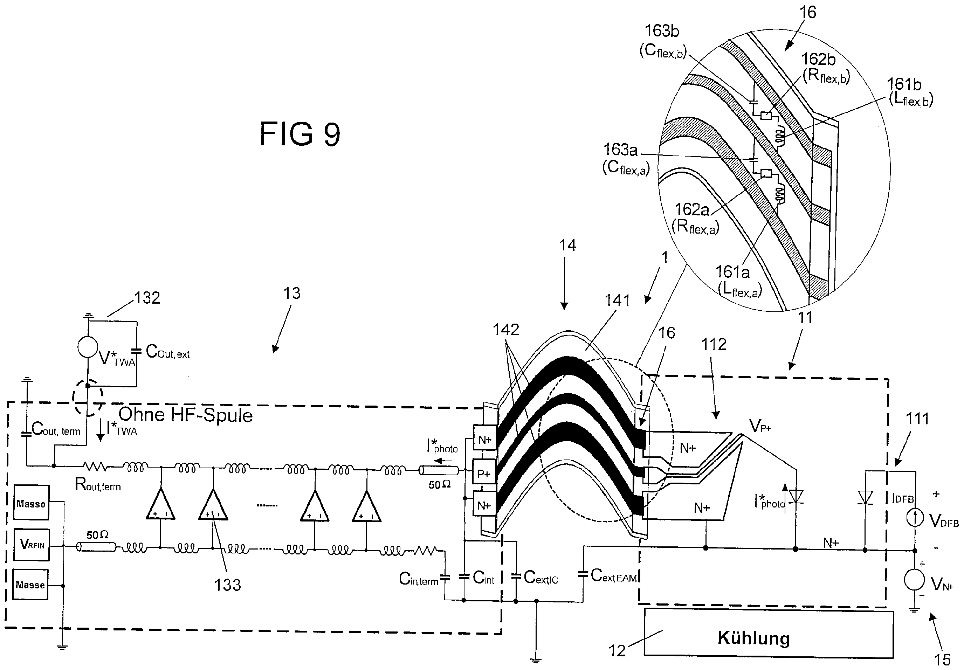

Das Ausführungsbeispiel der Figur 9 entspricht demjenigen der Figur 8, wobei jedoch auf die mit dem Treiber 13 gekoppelte HF-Terminierungsspule 131 verzichtet wurde. Entsprechend wird hier eine Versorgungsspannung V*_{TWA} unter Verwendung einer parallelen Kapazität C_{out, ext} über einen Anpassungswiderstand R_{out, term} dem Wanderwellenverstärker zugeführt. Die Kapazität C_{out,ext} zusammen mit einer weiteren Kapazität C_{out,term} realisieren eine breitbandige HF-Verbindung des Anpassungswiderstands R_{out, term} mit Masse.

Die Energieeinsparung bei der Versorgung des Treibers ergibt sich nach V*_{TWA} × I*ₚₕₒₜₒ, wobei V*_{TWA} = V_{TWA} + R_{out,term} × I*_{TWA}, I*_{TWA}= I_{TWA}.

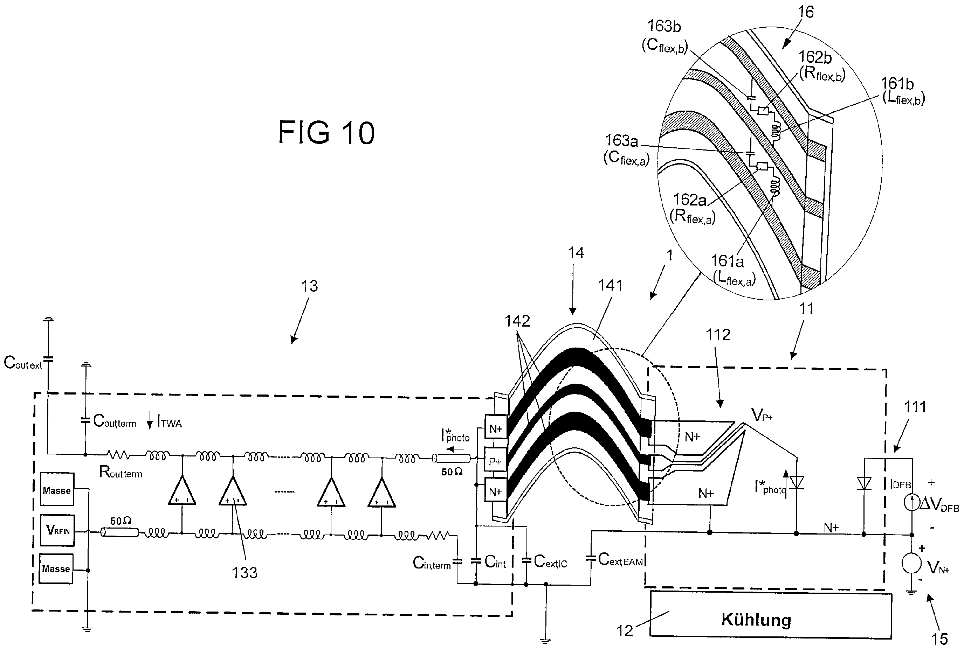

Gemäß dem Ausführungsbeispiel der Figur 10 entfällt auch die separate Spannungsquelle 132 zur zusätzlichen Versorgung des Treibers 13; d.h. der Treiber 13 wird allein durch den in der Elektroabsorptionsmodulatorsektion 112 des Lasers 11 erzeugten Fotostrom gespeist, wobei optional zusätzlich zu dem Fotostrom der über den Widerstand R_{flex} fließende Strom zur Versorgung des Treibers 13 dienen kann. Denkbar ist dafür, dass auf die Kapazität C_{flex} verzichtet wird.

Es wird darauf hingewiesen, dass Elemente der vorstehend beschriebenen Ausführungsbeispiele natürlich auch in Kombination miteinander verwendet werden können. Des Weiteren ist die Erfindung wie oben bereits erwähnt nicht auf einen hybriden Aufbau der Laseranordnung beschränkt. Insbesondere können die oben beschriebenen Ausführungsbeispiele analog auch mit einem monolithischen Aufbau der Laseranordnung realisiert werden.

## Patentansprüche

1. Laseranordnung, mit
- einem elektroabsorptionsmodulierten Laser (11), der eine Lasersektion (111) und eine Elektroabsorptionsmodulatorsektion (112) aufweist;
- einer Stromquelle (17) zur Stromversorgung der Lasersektion (111);
- einer zusätzlich zu der Stromquelle (17) angeordneten Gleichspannungsquelle (15), über die eine Gleichspannung (Vᵣₑᵥ) an eine Diodenstruktur (1121) der Elektroabsorptionsmodulatorsektion (112) angelegt werden kann;
- einem Treiber (13), mit dem dem Laser (11) ein HF-Signal zuführbar ist;
- einer elektrische Verbindung (14), über die der Treiber (13) mit dem Laser (11) verbunden ist,
**dadurch gekennzeichnet, dass** über die elektrische Verbindung (14) eine Gleichstromverbindung zwischen dem Treiber (13) und dem Laser (11) derart besteht und der Treiber derart ausgebildet ist, dass ein in der Elektroabsorptionsmodulatorsektion (112) des Lasers (11) durch Beleuchtung mit Licht der Lasersektion (111) erzeugter Fotostrom (Iₚₕₒₜₒ) zumindest teilweise dem Treiber (13) zufließt und zur Energieversorgung des Treibers (13) zumindest beiträgt.

2. Laseranordnung nach Anspruch 1, **dadurch gekennzeichnet, dass** über die elektrische Verbindung (14) auch eine HF-Verbindung zwischen dem Treiber (13) und dem Laser (11) besteht.

3. Laseranordnung nach Anspruch 2, **dadurch gekennzeichnet, dass** es sich bei der elektrischen Verbindung (14) um eine impedanzangepasste Leitung handelt.

4. Laseranordnung einem der vorhergehenden Ansprüche , **dadurch gekennzeichnet, dass** es sich bei dem Treiber um einen single-ended Verstärker handelt und dem Treiber das HF-Signal dadurch zuführbar ist, dass ein Eingang des Treibers mit einem zeitlich variierendem Potential beaufschlagt wird, wobei sich das HF-Signal als Differenz des variierenden Potentials mit einem zeitlich im Wesentlichen konstanten Referenzpotential ergibt.

5. Laseranordnung nach einem der vorhergehenden Ansprüche, **dadurch gekennzeichnet, dass** der Treiber (13) so ausgebildet ist und derart mit dem Laser (11) verschaltet ist, dass der Treiber (13) ausschließlich durch den in der Elektroabsorptionsmodulatorsektion (112) des Lasers (11) erzeugten Fotostrom (Iₚₕₒₜₒ) mit Energie versorgbar ist oder ein von der Stromquelle (17) generierter Strom zumindest im Wesentlichen nicht in den Treiber (13) fließt.

6. Laseranordnung nach einem der vorhergehenden Ansprüche, **dadurch gekennzeichnet, dass** der Treiber (13) so ausgebildet ist und derart mit dem Laser (11) verschaltet ist, dass der Treiber (13) seine Verstärkungseigenschaften beibehält, wenn er ausschließlich durch den in der Elektroabsorptionsmodulatorsektion (112) des Lasers (11) erzeugten Fotostrom (Iₚₕₒₜₒ) mit Energie versorgt wird.

7. Laseranordnung nach einem der vorhergehenden Ansprüche, **dadurch gekennzeichnet, dass** zwischen der Stromquelle (17) und der Elektroabsorptionsmodulatorsektion (112) keine elektrische Verbindung besteht oder eine während des Betriebes der Laseranordnung nicht stromführende elektrische Verbindung, insbesondere ausschließlich über mindestens eine dotierte Halbleiterschicht des Lasers, ausgebildet ist.

8. Laseranordnung nach einem der vorhergehenden Ansprüche, **dadurch gekennzeichnet, dass** zwischen der Stromquelle (17) und dem Treiber (13) keine elektrische Verbindung besteht oder eine während des Betriebes der Laseranordnung nicht stromführende elektrische Verbindung, insbesondere ausschließlich über mindestens eine dotierte Halbleiterschicht des Lasers, ausgebildet ist.

9. Laseranordnung nach einem der vorhergehenden Ansprüche, **dadurch gekennzeichnet, dass** zwischen der Gleichspannungsquelle (15) und der Lasersektion (111) keine elektrische Verbindung besteht oder eine elektrische Verbindung ausschließlich über mindestens eine dotierte Halbleiterschicht des Lasers ausgebildet ist.

10. Laseranordnung nach einem der vorhergehenden Ansprüche, **dadurch gekennzeichnet, dass** die Energieversorgung des Treibers (13) hauptsächlich durch den in der Elektroabsorptionsmodulatorsektion (112) des Lasers (11) erzeugten Fotostrom (Iₚₕₒₜₒ) erfolgt.

11. Laseranordnung nach einem der vorhergehenden Ansprüche, **dadurch gekennzeichnet, dass** die Energieversorgung des Treibers (13) zumindest im Wesentlichen allein durch den in der Elektroabsorptionsmodulatorsektion (112) des Lasers (11) erzeugten Fotostrom (Iₚₕₒₜₒ) erfolgt.

12. Laseranordnung nach einem der vorhergehenden Ansprüche, **dadurch gekennzeichnet, dass** die Laseranordnung (1) so ausgebildet ist, dass zumindest im Wesentlichen der gesamte in der Elektroabsorptionsmodulatorsektion erzeugte Fotostrom (Iₚₕₒₜₒ) zur Energieversorgung des Treibers (13) genutzt wird.

13. Laseranordnung nach einem der vorhergehenden Ansprüche, **gekennzeichnet durch** eine thermoelektrische Kühlvorrichtung (12) zum Kühlen des elektroabsorptionsmodulierten Lasers (11).

14. Array mit einer Mehrzahl von Laseranordnungen (1) nach einem der vorhergehenden Ansprüche.

15. Verfahren zum Herstellen einer Laseranordnung, insbesondere gemäß einem der vorhergehenden Ansprüche 1 bis 14, mit den Schritten:
- Bereitstellen eines elektroabsorptionsmodulierten Lasers (11), der eine Lasersektion (111) und eine Elektroabsorptionsmodulatorsektion (112) aufweist;
- Bereitstellen einer Stromquelle (17) zur Stromversorgung der Lasersektion (111) und einer zusätzlich zu der Stromquelle (17) angeordneten Gleichspannungsquelle (15), über die eine Gleichspannung (Vᵣₑᵥ) an eine Diodenstruktur (1121) der Elektroabsorptionsmodulatorsektion (112) angelegt werden kann;
- Bereitstellen eines Treibers (13), mit dem dem Laser (11) ein HF-Signal zuführbar ist;
- Herstellen einer elektrischen Verbindung (14) zwischen dem Treiber (13) und dem Laser (11),
**dadurch gekennzeichnet, dass**
die Laseranordnung (1) so konfiguriert wird, dass über die elektrische Verbindung (14) eine Gleichstromverbindung zwischen dem Treiber (13) und dem Laser (11) derart besteht, dass ein in der Elektroabsorptionsmodulatorsektion (112) des Lasers (11) durch Beleuchtung mit Licht der Lasersektion (111) erzeugter Fotostrom (Iₚₕₒₜₒ) zumindest teilweise dem Treiber (13) zufließt und zur Energieversorgung des Treibers (13) zumindest beiträgt.

## Claims

1. A laser arrangement, comprising
- an electro-absorption-modulated laser (11), which includes a laser section (111) and an electro-absorption modulator section (112);
- a power source (17) for supplying power to the laser section (111);
- a DC voltage source (15) arranged in addition to the power source (17), via which a DC voltage (Vᵣₑᵥ) can be applied to a diode structure (1121) of the electro-absorption modulator section (112);
- a driver (13), by which an HF signal can be supplied to the laser (11);
- an electrical connection (14), via which the driver (13) is connected to the laser (11),
**characterized in that**
via the electrical connection (14) a DC connection exists between the driver (13) and the laser (11) in such a way and the driver is formed in such a way that a photocurrent (Iₚₕₒₜₒ) generated in the electro-absorption modulator section (112) of the laser (11) by illumination with light of the laser section (111) at least partly flows to the driver (13) and at least contributes to the energy supply of the driver (13).

2. The laser arrangement according to claim 1, **characterized in that** via the electrical connection (14) there also exists an HF connection between the driver (13) and the laser (11).

3. The laser arrangement according to claim 2, **characterized in that** the electrical connection (14) is an impedance-matched line.

4. The laser arrangement according to any of the preceding claims, **characterized in that** the driver is a single-ended amplifier and the HF signal can be supplied to the driver by applying a time-varying potential to an input of the driver, wherein the HF signal is obtained as a difference between the varying potential and a temporally substantially constant reference potential.

5. The laser arrangement according to any of the preceding claims, **characterized in that** the driver (13) is configured such and connected to the laser (11) in such a way that the driver (13) can be supplied with energy exclusively by the photocurrent (Iₚₕₒₜₒ) generated in the electro-absorption modulator section (112) of the laser (11) or a current generated by the power source (17) at least substantially does not flow into the driver (13).

6. The laser arrangement according to any of the preceding claims, **characterized in that** the driver (13) is configured such and connected to the laser (11) in such a way that the driver (13) maintains its amplifying properties when it is supplied with energy exclusively by the photocurrent (Iₚₕₒₜₒ) generated in the electro-absorption modulator section (112) of the laser (11).

7. The laser arrangement according to any of the preceding claims, **characterized in that** between the power source (17) and the electro-absorption modulator section (112) no electrical connection exists or there is formed an electrical connection which is not current-carrying during the operation of the laser arrangement, in particular exclusively via at least one doped semiconductor layer of the laser.

8. The laser arrangement according to any of the preceding claims, **characterized in that** between the power source (17) and the driver (13) no electrical connection exists or there is formed an electrical connection which is not current-carrying during the operation of the laser arrangement, in particular exclusively via at least one doped semiconductor layer of the laser.

9. The laser arrangement according to any of the preceding claims, **characterized in that** between the DC voltage source (15) and the laser section (111) no electrical connection exists or an electrical connection is formed exclusively via at least one doped semiconductor layer of the laser.

10. The laser arrangement according to any of the preceding claims, **characterized in that** the energy supply of the driver (13) chiefly is effected by the photocurrent (Iₚₕₒₜₒ) generated in the electro-absorption modulator section (112) of the laser (11).

11. The laser arrangement according to any of the preceding claims, **characterized in that** the energy supply of the driver (13) at least substantially is effected solely by the photocurrent (Iₚₕₒₜₒ) generated in the electro-absorption modulator section (112) of the laser (11).

12. The laser arrangement according to any of the preceding claims, **characterized in that** the laser arrangement (1) is configured such that at least substantially the entire photocurrent (Iₚₕₒₜₒ) generated in the electro-absorption modulator section is used for the energy supply of the driver (13).

13. The laser arrangement according to any of the preceding claims, **characterized by** a thermoelectric cooling device (12) for cooling the electro-absorption-modulated laser (11).

14. An array with a plurality of laser arrangements (1) according to any of the preceding claims.

15. A method for manufacturing a laser arrangement, in particular according to any of the preceding claims 1 to 14, comprising the steps of:
- providing an electro-absorption-modulated laser (11) which includes a laser section (111) and an electro-absorption modulator section (112);
- providing a power source (17) for supplying power to the laser section (111) and a DC voltage source (15) arranged in addition to the power source (17), via which a DC voltage (Vᵣₑᵥ) can be applied to a diode structure (1121) of the electro-absorption modulator section (112);
- providing a driver (13) by which an HF signal can be supplied to the laser (11);
- producing an electrical connection (14) between the driver (13) and the laser (11),
**characterized in that**
the laser arrangement (1) is configured such that via the electrical connection (14) a DC connection exists between the driver (13) and the laser (11) in such a way that a photocurrent (Iₚₕₒₜₒ) generated in the electro-absorption modulator section (112) of the laser (11) by illumination with light of the laser section (111) at least partly flows to the driver (13) and at least contributes to the energy supply of the driver (13).

## Revendications

1. Dispositif laser, comprenant
- un laser modulé par électro-absorption (11), qui comprend une section laser (111) et une section modulateur à électro-absorption (112) ;
- une source de courant (17) pour alimenter la section laser (111) ;
- une source de tension continue (15) disposée en plus de la source de courant (17), par l'intermédiaire de laquelle une tension continue (Vᵣₑᵥ) peut être appliquée à une structure de diode (1121) de la section modulateur à électro-absorption (112) ;
- un pilote (13) avec lequel un signal HF peut être amené au laser (11) ;
- une connexion électrique (14) par laquelle le pilote (13) est relié au laser (11),
**caractérisé en ce que**
une connexion de courant continu est formée entre le pilote (13) et le laser (11) par l'intermédiaire de la connexion électrique (14) de telle sorte, et le pilote est conçu de telle sorte qu'un courant photoélectrique (Iₚₕₒₜₒ) généré dans la section modulateur à électro-absorption (112) du laser (11) par éclairage avec la lumière de la section laser (111) arrive au moins partiellement au pilote (13) et contribue au moins à l'alimentation en énergie du pilote (13).

2. Dispositif laser selon la revendication 1, **caractérisé en ce qu'**il existe également une connexion HF entre le pilote (13) et le laser (11) par l'intermédiaire de la connexion électrique (14).

3. Dispositif laser selon la revendication 2, **caractérisé en ce que** la connexion électricque (14) est une ligne à impédance adaptée.

4. Dispositif laser selon l'une quelconque des revendications précédentes, **caractérisé en ce que** le pilote est un amplificateur à extrémité unique et le signal HF peut être amené au pilote par le fait qu'une entrée du pilote est soumise à un potentiel variant dans le temps, le signal HF étant obtenu comme différence entre le potentiel variant et un potentiel de référence essentiellement constant dans le temps.

5. Dispositif laser selon l'une quelconque des revendications précédentes, **caractérisé en ce que** le pilote (13) est conçu et connecté au laser (11) de telle sorte que le pilote (13) peut être alimenté en énergie exclusivement par le courant photoélectrique (Iₚₕₒₜₒ) généré dans la section modulateur à électro-absorption (112) du laser (11) ou qu'un courant généré par la source de courant (17) n'arrive pas, du moins essentiellement, au pilote (13).

6. Dispositif laser selon l'une quelconque des revendications précédentes, **caractérisé en ce que** le pilote (13) est conçu et connecté au laser (11) de telle sorte que le pilote (13) conserve ses propriétés renforçantes lorsqu'il est alimenté en énergie uniquement par le courant photoélectrique (Iₚₕₒₜₒ) généré dans la section modulateur à électro-absorption (112) du laser (11).

7. Dispositif laser selon l'une quelconque des revendications précédentes, **caractérisé en ce qu'**il n'existe pas de connexion électrique entre la source de courant (17) et la section modulateur à électro-absorption (112) ou qu'une connexion électrique ne conduisant pas le courant pendant le fonctionnement du dispositif laser est formée, en particulier exclusivement par l'intermédiaire d'au moins une couche semi-conductrice dopée du laser.

8. Dispositif laser selon l'une quelconque des revendications précédentes, **caractérisé**en ce qu'il n'existe pas de connexion électrique entre la source de courant (17) et le pilote (13) ou qu'une connexion électrique ne conduisant pas le courant pendant le fonctionnement du dispositif laser est formée, en particulier uniquement par l'intermédiaire d'au moins une couche semi-conductrice dopée du laser.

9. Dispositif laser selon l'une quelconque des revendications précédentes, **caractérisé en ce qu'**il n'existe pas de connexion électrique entre la source de tension continue (15) et la section laser (111) ou qu'une connexion électrique est formée uniquement par l'intermédiaire d'au moins une couche semi-conductrice dopée du laser.

10. Dispositif laser selon l'une quelconque des revendications précédentes, **caractérisé en ce que** l'alimentation en énergie du pilote (13) est principalement effectuée par le courant photoélectrique (Iₚₕₒₜₒ) généré dans la section modulateur à électro-absorption (112) du laser (11).

11. Dispositif laser selon l'une quelconque des revendications précédentes, **caractérisé en ce que** l'alimentation en énergie du pilote (13) est effectuée au moins essentiellement par le seul courant photoélectrique (Iₚₕₒₜₒ) généré dans la section modulateur à électro-absorption (112) du laser (11).

12. Dispositif laser selon l'une quelconque des revendications précédentes, **caractérisé en ce que** le dispositif laser (1) est conçu de telle sorte qu'au moins sensiblement la totalité du courant photoélectrique (Iₚₕₒₜₒ) généré dans la section modulateur à électro-absorption est utilisée pour l'alimentation en énergie du pilote (13).

13. Dispositif laser selon l'une quelconque des revendications précédentes, **caractérisé par** un dispositif de refroidissement thermoélectrique (12) pour refroidir le laser modulé par électro-absorption (11).

14. Réseau comprenant une pluralité de dispositifs laser (1) selon l'une quelconque des revendications précédentes.

15. Procédé de fabrication d'un dispositif laser, en particulier selon l'une quelconque des revendications précédentes 1 à 14, avec les étapes :
- fournir un laser modulé par électro-absorption (11), qui comprend une section laser (111) et une section modulateur à électro-absorption (112) ;
- fournir une source de courant (17) pour alimenter la section laser (111) et une source de tension continue (15) disposée en plus de la source de courant (17), par l'intermédiaire de laquelle une tension continue (Vᵣₑᵥ) peut être appliquée à une structure de diode (1121) de la section modulateur à électro-absorption (112) ;
- fournir un pilote (13) avec lequel un signal HF peut être amené au laser (11) ;
- établir une connexion électrique (14) entre le pilote (13) et le laser (11),
**caractérisé en ce que**
le dispositif laser (1) est conçu de telle sorte qu'il existe une connexion de courant continu entre le pilote (13) et le laser (11) par l'intermédiaire de la connexion électrique (14) de telle sorte qu'un courant photoélectrique (Iₚₕₒₜₒ) généré dans la section modulateur à électro-absorption (112) du laser (11) par éclairage avec la lumière de la section de laser (111) arrive au moins partiellement au pilote (13) et contribue au moins à l'alimentation en énergie du pilote (13).
